# EUROPEAN PATENT APPLICATION

(11) **EP 4 745 944 A1**
(43) Date of publication of application: **20.05.2026**
(21) Application number: 24919637.9
(22) Date of filing: 19.06.2024
(51) Int. Cl.: G09F 9/30, H05K 7/02, H05K 7/00

(54) **FOLDABLE ELECTRONIC DEVICE**

(30) Priority: 25.01.2024 CN 202420191388 U
(71) Applicant: Huawei Technologies Co., Ltd., Shenzhen, Guangdong 518129 (CN)
(72) Inventor: YU, Weidong, Shenzhen, Guangdong 518129 (CN); MAO, Weihua, Shenzhen, Guangdong 518129 (CN); LV, Ren, Shenzhen, Guangdong 518129 (CN)
(74) Representative: Huawei European IPR
(86) International application number: PCT/CN2024/100027
(87) International publication number: WO 2025/156552

(57) **Abstract**

A foldable electronic device includes a foldable assembly (110) and a flexible display (120) laid on the foldable assembly (110). The foldable assembly (110) includes a first housing (111), a foldable mechanism (113), and a second housing (112) that are sequentially connected to each other. The foldable mechanism (113) includes a rotating shaft (113a). The foldable electronic device further includes a flexible cushioning layer (140) disposed between the flexible display (120) and the rotating shaft (113a). The flexible cushioning layer (140) includes a hollow part (149), and the hollow part (149) is adjacent to an end part of the rotating shaft (113a). In this way, impact resistance of the flexible display can be improved, and drop reliability of the flexible display can be improved.

## Description

This application claims priority to Chinese Patent Application No. 202420191388.7, filed with the China National Intellectual Property Administration on January 25, 2024 and entitled "FOLDABLE ELECTRONIC DEVICE", which is incorporated herein by reference in its entirety.

### TECHNICAL FIELD

This application relates to the field of terminal device technologies, and in particular, to a foldable electronic device.

### BACKGROUND

As terminal technologies continuously develop, a user has an increasingly high requirement for a large-size portable electronic device. Therefore, a foldable electronic device (for example, a foldable mobile phone) having a flexible display has attracted widespread attention. The foldable electronic device may be unfolded when being used, to provide a larger display interface and improve visual effect; and folded when not being used, to facilitate storage and carrying by the user.

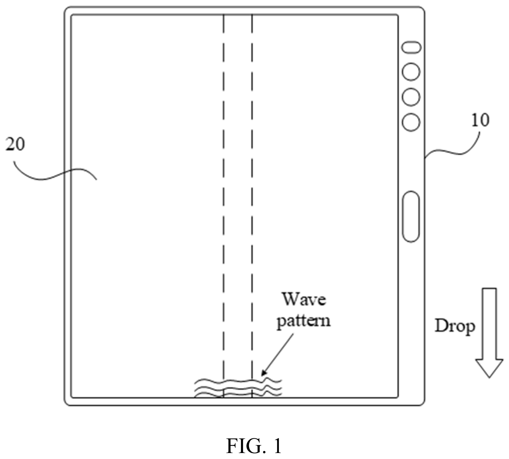

Foldable electronic devices may be classified by folding manner into types such as a vertically inward (small)-foldable type, a horizontally inward-foldable type, and a horizontally outward-foldable type. FIG. 1 is a diagram of a structure of a foldable electronic device of a horizontally outward-foldable type. As shown in FIG. 1, the foldable electronic device of the horizontally outward-foldable type is a device in which a body 10 of the device can be folded toward a back side of the body. After the body 10 is folded, a flexible display 20 wraps around the body 10, to form a wrap-around screen structure. When the body 10 is in an unfolded state, the flexible display 20 presents normal straight-screen display effect.

When the foldable electronic device is in the unfolded state shown in FIG. 1, a display region that is of the flexible display 20 and that is in a shaft region is in a relaxed state. In this case, in an event of a sudden drop or similar emergencies, a display region at an edge of the shaft region is prone to form a wave pattern under impact of an external force, and a very small bending radius of the wave pattern may lead to damage or failure of this part of display region. This affects user experience.

### SUMMARY

Embodiments of this application provide a foldable electronic device, to improve impact resistance of a flexible display and improve drop reliability of the flexible display.

According to a first aspect, a foldable electronic device is provided. The foldable electronic device includes a foldable assembly and a flexible display laid on the foldable assembly. The foldable assembly includes a first housing, a foldable mechanism, and a second housing that are sequentially connected to each other. The foldable mechanism includes a rotating shaft. The foldable electronic device further includes a flexible cushioning layer disposed between the flexible display and the rotating shaft. The flexible cushioning layer includes a hollow part, and the hollow part is adjacent to an end part of the rotating shaft.

According to the foldable electronic device provided in this embodiment of this application, the hollow part is disposed on the flexible cushioning layer located between the flexible display and the rotating shaft, and the hollow part is disposed adjacent to the end part of the rotating shaft. In other words, the hollow part is disposed adjacent to an edge or a frame of the foldable electronic device. The hollow part may be disposed to increase height (thickness) space. In this way, when the foldable electronic device drops accidentally, a wave pattern formed due to impact of an external force can be accommodated in the hollow part. In other words, the hollow part may be disposed to avoid the wave pattern, so that a bending radius of the wave pattern is not very small. This protects a bendable display part of the flexible display, and improves impact resistance and drop reliability of the flexible display, thereby improving user experience.

In a possible implementation, the hollow part includes a hole structure and/or a notch structure.

Optionally, the hole structure may be, for example, a through hole, a blind hole, or a buried via provided inside the flexible cushioning layer. The notch structure may be, for example, any regular or irregular notch structure like a U-shaped notch structure, a V-shaped notch structure, a C-shaped notch structure, or a wave-shaped notch structure disposed at an edge of the flexible cushioning layer.

In a possible implementation, the flexible cushioning layer includes a first support layer and a first cushioning layer that are stacked, and an elastic modulus of the first support layer is greater than an elastic modulus of the first cushioning layer.

The flexible cushioning layer provided in this application is formed by stacking a plurality of sheets including the first support layer and the first cushioning layer, and the elastic modulus of the first support layer is greater than the elastic modulus of the first cushioning layer. In this way, the first support layer having a greater elastic modulus helps provide a support force for the flexible display, and reduce a possibility that the flexible display is recessed toward the inside of the device under impact. In addition, because the first support layer has a greater elastic modulus, an overall deformation amount of the first support layer is smaller under impact waves, and the first support layer is not prone to local stress concentration, so that the impact waves are easily to be dispersed on the first support layer. However, the first cushioning layer has a lower elastic modulus, and can absorb impact waves through greater elastic deformation. This helps absorb impact waves from the flexible display, and reliably protect the flexible display. In this application, the first support layer and the first cushioning layer are mutually matched and combined to form the flexible cushioning layer, so that the flexible cushioning layer can have both cushioning protection effect and supporting effect on the flexible display, and further have good bending performance. This improves use performance of the foldable electronic device.

In a possible implementation, the flexible cushioning layer includes an under-screen cushioning layer and an on-shaft cushioning layer that are stacked. The under-screen cushioning layer includes a first adhesive layer and the first support layer, and the first support layer is fastened to the flexible display through the first adhesive layer. The on-shaft cushioning layer includes the first cushioning layer, a second adhesive layer, and a second support layer that are sequentially stacked, and the second support layer is fastened to the rotating shaft.

In this application, the flexible cushioning layer is divided into two parts. One part (namely, the under-screen cushioning layer) is fixedly bonded to the flexible display, and the other part (namely, the on-shaft cushioning layer) is fastened to the rotating shaft. In this way, when the flexible cushioning layer is assembled, the under-screen cushioning layer may be first reliably bonded to the back side of the flexible display, and the on-shaft cushioning layer is fastened (for example, welded) to the rotating shaft. Then, the flexible cushioning layer may be assembled by assembling the flexible display. To be specific, after the flexible display is assembled on the foldable assembly, the under-screen cushioning layer is automatically attached to the on-shaft cushioning layer. This can simplify assembling steps and improve assembling reliability of the flexible cushioning layer.

In a possible implementation, the under-screen cushioning layer further includes a third adhesive layer and a second cushioning layer. The first adhesive layer, the first support layer, the third adhesive layer, and the second cushioning layer are sequentially stacked; or the first adhesive layer, the second cushioning layer, the third adhesive layer, and the first support layer are sequentially stacked.

In a possible implementation, the on-shaft cushioning layer further includes a lubricating layer located between the under-screen cushioning layer and the first cushioning layer.

The lubricating layer can achieve lubricating effect. The lubricating layer may be disposed to reduce a friction force between the under-screen cushioning layer and the on-shaft cushioning layer, so that the under-screen cushioning layer and the on-shaft cushioning layer are more likely to have mutual misalignment in a folding process. In this way, a folding feel of the foldable electronic device can be improved.

Optionally, the lubricating layer may be a lubricating coating layer including lubricating oil or grease.

In a possible implementation, the lubricating layer includes a mylar film.

The mylar film may be coated on a surface of the first cushioning layer. The mylar film has self-lubricating performance, and can reduce friction between the under-screen cushioning layer and the mylar film, and facilitate mutual sliding between the under-screen cushioning layer and the on-shaft cushioning layer during folding. For example, the mylar film may be a PET mylar film or a teflon (teflon) mylar film.

In a possible implementation, a through hole is provided in a middle part of the on-shaft cushioning layer, and the under-screen cushioning layer is bonded to the rotating shaft by using glue in the through hole.

In this way, the under-screen cushioning layer can be directly fastened to the rotating shaft without using the on-shaft cushioning layer. This can improve reliability of a connection between the bendable display part and the rotating shaft, effectively prevent a risk like warping of the bendable display part, and help keep the bendable display part flat.

In a possible implementation, the through hole includes a first hole provided at the second adhesive layer and a second hole provided at the second support layer. The first hole and the second hole are opposite to each other, and a cross-sectional area of the second hole is less than a cross-sectional area of the first hole.

A width of the rotating shaft is small, and the second hole has a smaller cross-sectional area, so that overflow of the glue from the hole can be avoided, more glue can be accommodated in the hole, and a part of a wall surface of the second support layer is exposed. In this way, the under-screen cushioning layer can be bonded to both the rotating shaft and the second support layer, so that connection reliability can be improved.

In a possible implementation, the second support layer includes a metal layer, and the metal layer is welded to the rotating shaft.

Compared with bonding, welding has stronger connection reliability. In other words, reliability of a connection between the on-shaft cushioning layer and the rotating shaft can be improved. For example, the second support layer is a steel sheet, and there are a plurality of welding spot regions on the steel sheet for welding and fastening to the rotating shaft.

In a possible implementation, a welding avoidance hole is provided in a middle part of the on-shaft cushioning layer, and the welding avoidance hole penetrates from a surface of a side that is of the on-shaft cushioning layer and that is away from the metal layer to the metal layer, to expose the metal layer. This facilitates a welding operation performed by a welding joint on the metal layer and the rotating shaft.

In a possible implementation, the under-screen cushioning layer includes a plurality of functional film layers that are sequentially stacked, and the hollow part is disposed on one or more of the plurality of functional film layers.

In other words, the hollow part may be disposed on one or more functional film layers of the under-screen cushioning layer, instead of being disposed on all functional film layers. In other words, a part of functional film layers of the under-screen cushioning layer may not be hollow. In this way, the hollow part can be disposed more flexibly, so that the hollow part can reliably avoid a wave pattern, and further helps ensure that the flexible cushioning layer has good supporting effect on the flexible display.

In a possible implementation, the first housing includes a first middle frame. The second housing includes a second middle frame. The foldable electronic device further includes a screen holding plate including a first holding part, a bendable holding part, and a second holding part that are sequentially connected to each other. The first holding part is located between the flexible display and the first middle frame. The bendable holding part is located between the flexible display and the flexible cushioning layer. The second holding part is located between the flexible display and the second middle frame.

In some examples, in a width direction perpendicular to the rotating shaft (namely, a radial direction of the rotating shaft), a width of the under-screen cushioning layer is greater than a width of the bendable holding part.

Both the under-screen cushioning layer and the bendable holding part are of a rectangular structure. A long side of the rectangular structure is disposed in an axial direction of the rotating shaft, and a short side of the rectangular structure is disposed in a direction (namely, the width direction) perpendicular to the rotating shaft. In this application, the width of the under-screen cushioning layer is set to be greater than the width of the bendable holding part, that is, a length of a short side of the under-screen cushioning layer is greater than a length of a short side of the bendable holding part, so that the flexible display can be better supported and protected.

### BRIEF DESCRIPTION OF DRAWINGS

FIG. 1 is a diagram of a structure of a foldable electronic device of a horizontally outward-foldable type;
FIG. 2 is a diagram of structures of a foldable electronic device before and after folding according to an embodiment of this application;
FIG. 3 is an exploded view of a foldable electronic device according to an embodiment of this application;
FIG. 4 is a diagram of a structure of a flexible cushioning layer according to an embodiment of this application;
FIG. 5 is an enlarged view of an end part of a flexible cushioning layer according to an embodiment of this application;
FIG. 6 is an enlarged view of an end part of another example of a flexible cushioning layer according to an embodiment of this application;
FIG. 7 is a diagram of a plurality of implementations of a hollow part according to an embodiment of this application;
FIG. 8 is an exploded view of a flexible cushioning layer according to an embodiment of this application;
FIG. 9 is an exploded view of another example of an under-screen cushioning layer according to an embodiment of this application;
FIG. 10 is a partial diagram of an on-shaft cushioning layer according to an embodiment of this application;
FIG. 11 is a diagram of a structure of another example of an on-shaft cushioning layer according to an embodiment of this application;
FIG. 12 is a partially enlarged view of a part A of the on-shaft cushioning layer shown in FIG. 11; and
FIG. 13 is an exploded view of the on-shaft cushioning layer shown in FIG. 11.

### Reference numerals:

10: body; 20: flexible display;
100: foldable electronic device;
110: foldable assembly; 111: first housing; 111a: first middle frame; 111b: first frame; 112: second housing; 112a: second middle frame; 112b: second frame; 113: foldable mechanism; 113a: rotating shaft;
120: flexible display; 121: first display part; 122: second display part; 123: bendable display part;
130: screen holding plate; 131: first holding part; 132: second holding part; 133: bendable holding part;
140: flexible cushioning layer; 141: first adhesive layer; 142: first support layer; 143: lubricating layer; 143a: first lubricating part; 143b: second lubricating part; 143c: third lubricating part; 144: first cushioning layer; 145: second adhesive layer; 146: second support layer; 147: third adhesive layer; 148: second cushioning layer; 149: hollow part; 140a: under-screen cushioning layer; 140b: on-shaft cushioning layer; 140c: through hole; 140c1: first hole; 140c2: second hole; 140c3: third hole; 140c4: fourth hole; 140d: welding avoidance hole; and
150: back adhesive.

### DESCRIPTION OF EMBODIMENTS

The following describes implementations of this application in detail. Examples of the implementations are shown in the accompanying drawings. Same or similar reference numerals always indicate same or similar elements or elements having same or similar functions. The implementations described below with reference to the accompanying drawings are examples, and are merely used to explain this application, but cannot be understood as a limitation on this application.

In the descriptions of this application, it should be noted that, unless otherwise specified and limited, terms "mounting", and "connection" should be understood in a broad sense. For example, a connection may be a fastening connection, a detachable connection, or an integrated connection. Alternatively, a connection may be a mechanical connection, an electrical connection, or mutual communication. Alternatively, a connection may be a direct connection, or an indirect connection through an intermediate medium, or may be a connection between two elements or an interaction relationship between two elements. A person of ordinary skill in the art may interpret specific meanings of the foregoing terms in this application according to specific cases.

In the descriptions of this application, it should be understood that orientation or position relationships indicated by terms such as "upper", "lower", "side", "front", and "rear" are based on orientation or position relationships of mounting, and are used only for ease and brevity of illustration and description of this application, rather than indicating or implying that the mentioned apparatus or element needs to have a particular orientation or needs to be constructed and operated in a particular orientation. Therefore, such terms should not be understood as a limitation on this application.

The terms "first" and "second" mentioned below are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of embodiments of this application, unless otherwise specified, "a plurality of" means two or more.

The term "and/or" in this specification describes only an association relationship for describing associated objects and indicates that three relationships may exist. For example, A and/or B may indicate the following three cases: Only A exists, both A and B exist, and only B exists. In addition, the character "/" in this specification generally indicates an "or" relationship between the associated objects.

Based on a problem in the conventional technology, an embodiment of this application provides a foldable electronic device, to improve impact resistance of a flexible display and improve drop reliability of the flexible display.

The foldable electronic device provided in embodiments of this application may be a terminal product like a mobile phone, a tablet computer, a notebook computer, an e-reader, a television, a smart wearable product (for example, a smartwatch or a smart band), a virtual reality (virtual reality, VR) device, or an augmented reality (augmented reality, AR) device. The following uses only an example in which the foldable electronic device is a foldable mobile phone for description.

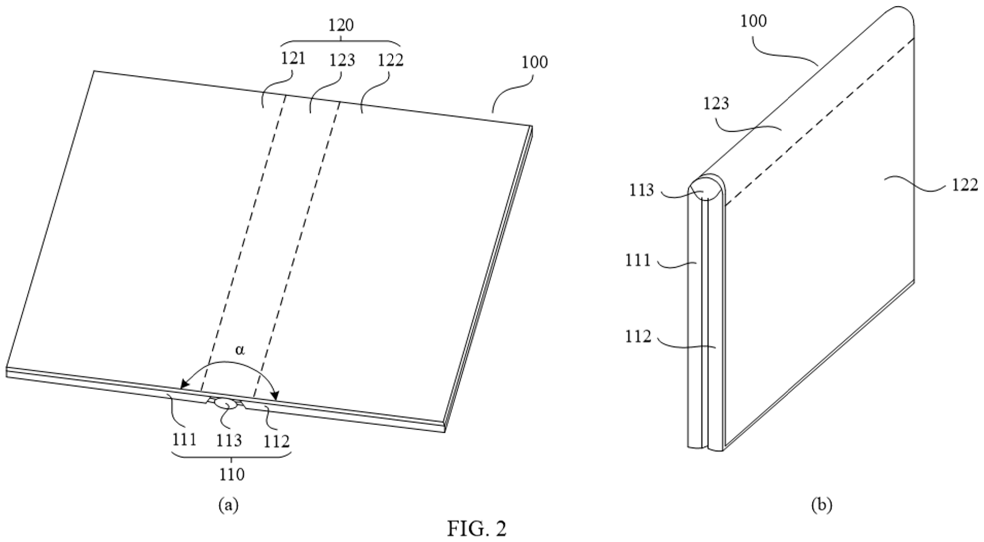

FIG. 2 is a diagram of structures of a foldable electronic device 100 before and after folding according to an embodiment of this application. Herein, (a) in FIG. 2 is a diagram of a structure of the foldable electronic device 100 in an unfolded state, and (b) in FIG. 2 is a diagram of a structure of the foldable electronic device 100 in a folded state.

As shown in FIG. 2, the foldable electronic device 100 has a flexible display 120. The flexible display 120 has a foldable feature, so that the foldable electronic device 100 can be folded, for example, can be folded outward in a horizontal direction. After being folded, the flexible display 120 is divided into a plurality of parts, for example, including a front display part facing a user, and a back display part opposite to the front display part and on a back side. When the foldable electronic device 100 is in the unfolded state, the user may perform human-machine interaction through the complete flexible display 120. In this case, the user has good visual effect. When the foldable electronic device 100 is in the folded state, the user may perform human-machine interaction through the front display part of the flexible display 120, to meet a basic use requirement of the user, and facilitate storage and carrying of the foldable electronic device 100 by the user.

As shown in FIG. 2, the foldable electronic device 100 includes a foldable assembly 110 and the flexible display 120. The foldable assembly 110 constructs an appearance of the foldable electronic device 100. The foldable assembly 110 may be a metal housing like a magnesium alloy housing, an aluminum alloy housing, or a stainless steel housing. Alternatively, the foldable assembly 110 may be a plastic housing, a glass housing, a ceramic housing, or the like, but is not limited thereto. The foldable assembly 110 usually includes structures such as a frame, a middle frame, and a rear cover. A mounting cavity is provided inside the foldable assembly 110. Various electronic elements are mounted in the mounting cavity, for example, a circuit board, a processor disposed on the circuit board, a battery, and various functional elements such as a camera, a flash, a microphone, and a speaker, but are not limited thereto.

The foldable electronic device 100 further includes the flexible display 120 disposed on the foldable assembly 110. The flexible display 120 is used as a front panel of the device, and forms the mounting cavity with the foldable assembly 110. The flexible display 120 forms a display surface of the foldable electronic device 100, and is configured to: display information such as an image and a text, and provide information interaction. The flexible display 120 is flexible and bendable. For example, the flexible display 120 may be an organic light-emitting diode (organic light-emitting diode, OLED) display, an active-matrix organic light-emitting diode (active-matrix organic light-emitting diode, AMOLED) display, a mini light-emitting diode (mini organic light-emitting diode) display, a micro light-emitting diode (micro organic light-emitting diode) display, a micro organic light-emitting diode (micro organic light-emitting diode) display, a quantum dot light-emitting diode (quantum dot light-emitting diode, OLED) display, or the like, but is not limited thereto.

As shown in FIG. 2, the foldable assembly 110 includes a plurality of parts, including a first housing 111, a foldable mechanism 113, and a second housing 112 that are sequentially connected to each other. The foldable mechanism 113 is deformable to enable the first housing 111 and the second housing 112 to be unfolded or folded relative to each other. The flexible display 120 includes a first display part 121, a bendable display part 123, and a second display part 122 that are sequentially connected to each other. The first housing 111 is fastened to the first display part 121, the second housing 112 is fastened to the second display part 122, and the foldable mechanism 113 is opposite to the bendable display part 123.

As shown in (a) in FIG. 2, the first housing 111 and the second housing 112 can be unfolded relative to each other to be completely unfolded, so that the foldable electronic device 100 is in an unfolded state. When the first housing 111 and the second housing 112 are completely unfolded, an included angle α between the first housing 111 and the second housing 112 may be approximately 180° (a small deviation is also allowed, for example, the included angle is 165°, 177°, or 185°).

As shown in (b) in FIG. 2, the first housing 111 and the second housing 112 can be folded relative to each other to be folded, so that the foldable electronic device 100 is in a folded state. In this case, the first housing 111 and the second housing 112 are parallel to each other (a small deviation is also allowed). In other words, the foldable electronic device 100 may switch between the unfolded state and the folded state through deformation of the foldable mechanism 113. In some embodiments, the foldable electronic device 100 may further enable, through deformation of the foldable mechanism 113, the first housing 111 and the second housing 112 to be unfolded/folded relative to each other until the foldable electronic device 100 is in a partially unfolded state, in other words, the first housing 111 and the second housing 112 are in an intermediate state between the completely unfolded state and the completely folded state. For example, when the first housing 111 and the second housing 112 are partially unfolded, the included angle α between the first housing 111 and the second housing 112 may be approximately 60°, 120°, 135°, 150°, or the like. This is not strictly limited in this application.

In this embodiment of this application, the flexible display 120 can be bent with the foldable assembly 110. When the foldable electronic device 100 is in the unfolded state shown in (a) in FIG. 2, the flexible display 120 is unfolded, and can be used for full-screen display, so that the foldable electronic device 100 has a large display area, to improve viewing experience of the user. When the foldable electronic device 100 is in the folded state shown in (b) in FIG. 2, the flexible display 120 is folded on an outer side of the foldable assembly 110, so that the foldable electronic device 100 has a smaller planar size, to facilitate carrying and storage by the user.

The foldable mechanism 113 includes but is not limited to one or more of a rotating shaft, a gear, a hinge, a sliding block, a sliding groove, a pin shaft, a connecting rod, a sliding rod, a swing rod, or the like. In addition, the foldable mechanism 113 may be made of an elastic material, a memory alloy material, or the like.

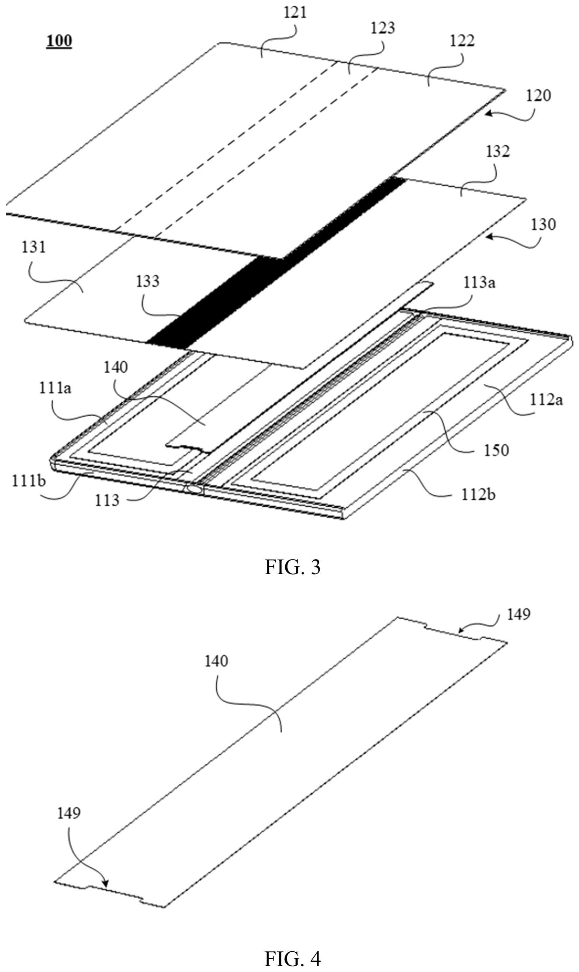

FIG. 3 is an exploded view of the foldable electronic device 100 according to an embodiment of this application. As shown in FIG. 3, in this embodiment of this application, the foldable mechanism 113 includes a rotating shaft 113a, and the first housing 111 is hinged to the second housing 112 through the rotating shaft 113a. In other words, the first housing 111 and the second housing 112 may rotate relative to each other through the rotating shaft 113a, so that the foldable electronic device 100 can be switched between the completely unfolded state and the folded state.

As shown in FIG. 3, the foldable electronic device 100 provided in this embodiment of this application further includes a screen holding plate 130. The screen holding plate 130 is located between the flexible display 120 and the foldable assembly 110. One surface of the screen holding plate 130 is fixedly bonded to the flexible display 120, and the other surface of the screen holding plate 130 is fixedly bonded to the foldable assembly 110. The flexible display 120 is fixedly laid on the foldable assembly 110 through the screen holding plate 130. In some cases, the screen holding plate 130 may be considered as a part of the flexible display 120.

The screen holding plate 130 is configured to: support and fasten the flexible display 120. The screen holding plate 130 can provide a support force for the flexible display 120, so that the flexible display 120 can be maintained in at least the unfolded state or the folded state according to a requirement. In other words, the screen holding plate 130 not only needs to have sufficient bending performance to be bent to a required position (angle) when necessary, but also needs to have a capability of maintaining at the corresponding position, to provide a support force for the flexible display 120. For example, a material of the screen holding plate 130 may be at least one of materials such as carbon fiber, aramid fiber, glass fiber, polyvinyl alcohol (polyvinyl alcohol, PVA) high-modulus fiber, stainless steel, titanium alloy, copper alloy, and aluminum alloy, but is not limited thereto.

As shown in FIG. 3, the screen holding plate 130 includes a first holding part 131, a bendable holding part 133, and a second holding part 132 that are sequentially connected to each other. The first holding part 131 is fastened between the first housing 111 and the first display part 121. In other words, the first display part 121 is fastened to the first housing 111 through the first holding part 131. The bendable holding part 133 is disposed between the foldable mechanism 113 and the bendable display part 123. The second holding part 132 is fastened between the second housing 112 and the second display part 122. In other words, the second display part 122 is fastened to the second housing 112 through the second holding part 132.

For example, the first housing 111 includes a first middle frame 111a of a flat plate structure, and a first frame 111b that is of a U-shaped opening structure and that surrounds the first middle frame 111a. The second housing 112 includes a second middle frame 112a of a flat plate structure, and a second frame 112b that is of a U-shaped opening structure and that surrounds the second middle frame 112a. An opening of the first frame 111b and an opening of the second frame 112b are opposite to each other, and a plate surface of the first middle frame 111a and a plate surface of the second middle frame 112a are approximately parallel to each other and have approximately a same height. The first middle frame 111a is rotatably connected to the second middle frame 112a through the foldable mechanism 113 (for example, the rotating shaft 113a).

An upper surface (an outer surface) of the first holding part 131 may be fixedly bonded to a back side of the first display part 121, and a lower surface (an inner surface) of the first holding part 131 may be fixedly bonded to the first middle frame 111a by using a back adhesive 150. An upper surface of the second holding part 132 may be fixedly bonded to a back side of the second display part 122, and a lower surface of the second holding part 132 may be fixedly bonded to the second middle frame 112a by using the back adhesive 150. An upper surface of the bendable holding part 133 may be fixedly bonded to the bendable display part 123.

When the screen holding plate 130 is bent, the bendable holding part 133 generates internal stress due to deformation. If the internal stress is very large, a folding operation performed by the user on the foldable electronic device 100 is laborious, and the screen holding plate 130 may be damaged. As shown in FIG. 3, to reduce the internal stress generated when the screen holding plate 130 is bent, the bendable holding part 133 of the screen holding plate 130 may include a mesh structure. The mesh structure may include an array including a plurality of hole structures that are spaced from each other. The mesh structure provides greater deformation space for the screen holding plate 130. This helps reduce rigidity of the screen holding plate 130, reduce the internal stress generated when the screen holding plate 130 is bent, and improve bending performance of the support plate, thereby improving a folding feel of the foldable electronic device 100.

In some examples, the mesh structure may include a through hole and/or a blind hole. For example, the mesh structure may include a plurality of bar-shaped through holes, and a length direction of at least a part of the bar-shaped through holes is perpendicular to an axis direction of the rotating shaft 113a, or a length direction of at least a part of the bar-shaped through holes is parallel to an axis direction of the rotating shaft 113a.

In some examples, the bendable holding part 133 may be a bracket. In other words, the bendable holding part 133 may also be referred to as a bracket.

As shown in FIG. 3, the foldable electronic device 100 provided in this embodiment of this application further includes a flexible cushioning layer 140 that is bendable. The flexible cushioning layer 140 is integrally rectangular (bar-shaped), and a long side of the flexible cushioning layer 140 is disposed in an axial direction of the rotating shaft 113a. For example, the long side may be parallel to the axis direction of the rotating shaft 113a. The flexible cushioning layer 140 is disposed between the bendable holding part 133 and the rotating shaft 113a, that is, the flexible cushioning layer 140 is disposed between the flexible display 120 and the rotating shaft 113a. The flexible cushioning layer 140 is configured to provide a cushioning function for the flexible display 120, to reduce impact of an external force on the flexible display 120. In other words, the flexible display 120 can be protected to a specific extent.

In some examples, the flexible cushioning layer 140 may be made of a material with specific elasticity, such as foam, foam rubber, sponge rubber, plastic (plastic), rubber, thermoplastic polyurethane (thermoplastic polyurethane, TPU), polycarbonate (polycarbonate, PC), polyimide (polyimide, PI), and polyethylene terephthalate (polyethylene terephthalate, PET).

In some examples, the flexible cushioning layer 140 may be formed by cutting a sheet made of a same material. For example, the flexible cushioning layer 140 may be a TPU sheet. Alternatively, the flexible cushioning layer 140 may be formed through composite stacking of a plurality of sheets, and materials of at least two sheets in the plurality of sheets are different.

In some examples, an upper surface of the flexible cushioning layer 140 is fixedly bonded to the bendable holding part 133, and a lower surface of the flexible cushioning layer 140 is fastened (for example, bonded or welded) to the rotating shaft 113a, so that the bendable display part 123 of the flexible display 120 can be fastened to the rotating shaft 113a through the bendable holding part 133 and the flexible cushioning layer 140 in sequence. This can prevent a risk like warping of the bendable display part 123, and helps keep the bendable display part 123 flat.

FIG. 4 is a diagram of a structure of the flexible cushioning layer 140 according to an embodiment of this application. As shown in FIG. 3 and FIG. 4, the flexible cushioning layer 140 further includes a hollow part 149, and the hollow part 149 is adjacent to an end part of the rotating shaft 113a. For example, the hollow part 149 may be disposed on a short side of the rectangular flexible cushioning layer 140. For example, the hollow part 149 is disposed on one of two short sides, or hollow parts 149 are disposed on both of the two short sides.

In some examples, there may be one or more hollow parts 149. For example, the hollow part 149 may include at least one hole structure and/or at least one notch structure. The hole structure may be, for example, a through hole, a blind hole, or a buried via provided inside the flexible cushioning layer 140. The notch structure may be, for example, any regular or irregular notch structure like a U-shaped notch structure, a V-shaped notch structure, a C-shaped notch structure, or a wave-shaped notch structure disposed at an edge of the flexible cushioning layer 140.

According to the foldable electronic device 100 provided in this embodiment of this application, the hollow part 149 is disposed on the flexible cushioning layer located between the flexible display 120 and the rotating shaft 113a, and the hollow part 149 is disposed adjacent to the end part of the rotating shaft 113a. In other words, the hollow part 149 is disposed adjacent to an edge or a frame of the foldable electronic device 100. The hollow part 149 may be disposed to increase height (thickness) space. In this way, when the foldable electronic device 100 drops accidentally, a wave pattern formed due to impact of an external force can be accommodated in the hollow part 149. In other words, the hollow part 149 may be disposed to avoid the wave pattern, so that a bending radius of the wave pattern is not very small. This protects the bendable display part 123 of the flexible display 120, and improves impact resistance and drop reliability of the flexible display 120, thereby improving user experience.

In some examples, there are a plurality of hollow parts 149, and one or more of the hollow parts 149 are disposed adjacent to one end part of the rotating shaft 113a, and remaining one or more hollow parts 149 are disposed adjacent to the other end part of the rotating shaft 113a. In this way, regardless of which end of the foldable electronic device 100 lands first, the bending radius of the wave pattern is not very small, so that the flexible display 120 can be reliably protected, and impact resistance and drop reliability of the flexible display 120 are further improved.

For example, as shown in FIG. 4, one hollow part 149 is disposed on each of the two short sides of the flexible cushioning layer 140, that is, one notch structure is disposed on each short side. In this way, regardless of which shaft end lands first, the flexible display 120 can be reliably protected.

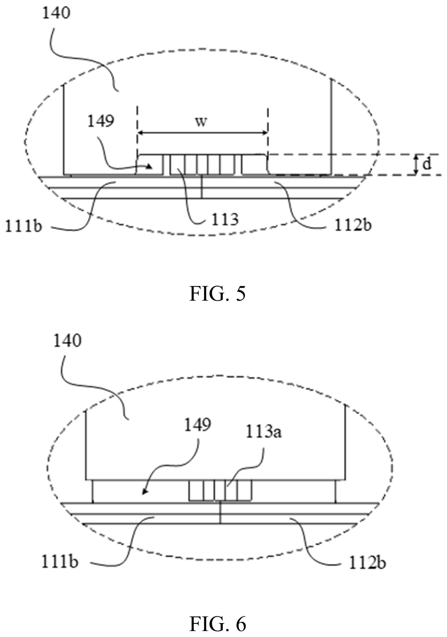

FIG. 5 is an enlarged view of an end part of the flexible cushioning layer 140 according to an embodiment of this application. As shown in FIG. 5, the hollow part 149 may be of a U-shaped notch structure. The hollow part 149 is disposed on a short side of the flexible cushioning layer 140 and overlaps an end part of the rotating shaft 113a. The hollow part 149 is adjacent to the first frame 111b and the second frame 112b. In this way, when the foldable electronic device 100 drops accidentally, a wave pattern formed due to impact of an external force can be accommodated in the hollow part 149, so that a bending radius of the wave pattern is not very small. In this way, drop protection is implemented for the flexible display 120. For example, a width w of the hollow part 149 is greater than or equal to (≥) 3.0 millimeters (mm), and a depth d of the hollow part 149 is greater than or equal to 0.3 mm and less than or equal to (≤) 3.0 mm. For example, the width w of the hollow part 149 may be 3.5 mm, 4.0 mm, 4.5 mm, 5.0 mm, or the like, and the depth d of the hollow part 149 may be 0.5 mm, 0.8 mm, 1.2 mm, 1.5 mm, 2.0 mm, or the like.

FIG. 6 is an enlarged view of an end part of another example of the flexible cushioning layer 140 according to an embodiment of this application. In a special example, as shown in FIG. 6, the hollow part 149 may alternatively be a gap provided between an edge of the flexible cushioning layer 140 and an inner wall of a frame. In this case, a short side of the flexible cushioning layer 140 still remains straight, for example, is parallel or approximately parallel to the inner wall of the frame. The gap may be considered as a part of the flexible cushioning layer 140, and can also accommodate a wave pattern, to implement drop protection for the flexible display 120.

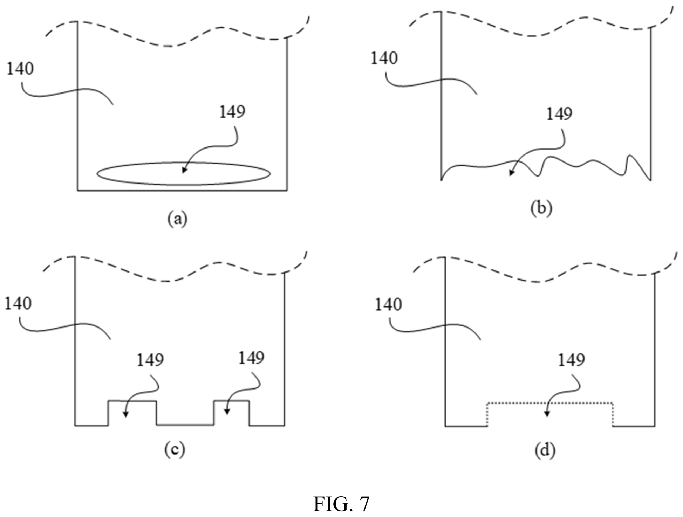

FIG. 7 is a diagram of a plurality of implementations of the hollow part 149 according to an embodiment of this application. As shown in (a) in FIG. 7, the hollow part 149 may be of a hole structure disposed inside the flexible cushioning layer 140. The hole structure is disposed adjacent to an edge of a shaft end, for example, may be a through hole, a blind hole, or a buried via. A cross-sectional shape of the hole structure may be, for example, any shape like an ellipse, a rectangle, a track, or a circle. As shown in (b) in FIG. 7, the hollow part 149 may be of a notch structure formed at an edge of the flexible cushioning layer 140. The notch structure is disposed adjacent to an edge of a shaft end, for example, may be any regular or irregular notch-shaped structure like a waveform-shaped notch structure, a sawtooth-shaped notch structure, a U-shaped notch structure, a V-shaped notch structure, or a C-shaped notch structure. As shown in (c) in FIG. 7, the hollow part 149 may be of a notch structure formed at an edge of the flexible cushioning layer 140. The notch structure is disposed adjacent to an edge of a shaft end, and there are a plurality of notch structures, for example, may be two, three, or four notch structures. As shown in (d) in FIG. 7, the hollow part 149 may be of a notch structure formed at an edge of the flexible cushioning layer 140. The notch structure is disposed adjacent to an edge of a shaft end, and the notch structure does not penetrate upper and lower surfaces of the flexible cushioning layer 140. For example, the flexible cushioning layer 140 may be formed through composite stacking of a plurality of sheets. The notch structure may be formed on one or more middle sheets, and a topmost sheet or a bottommost sheet may be a complete structure without a notch.

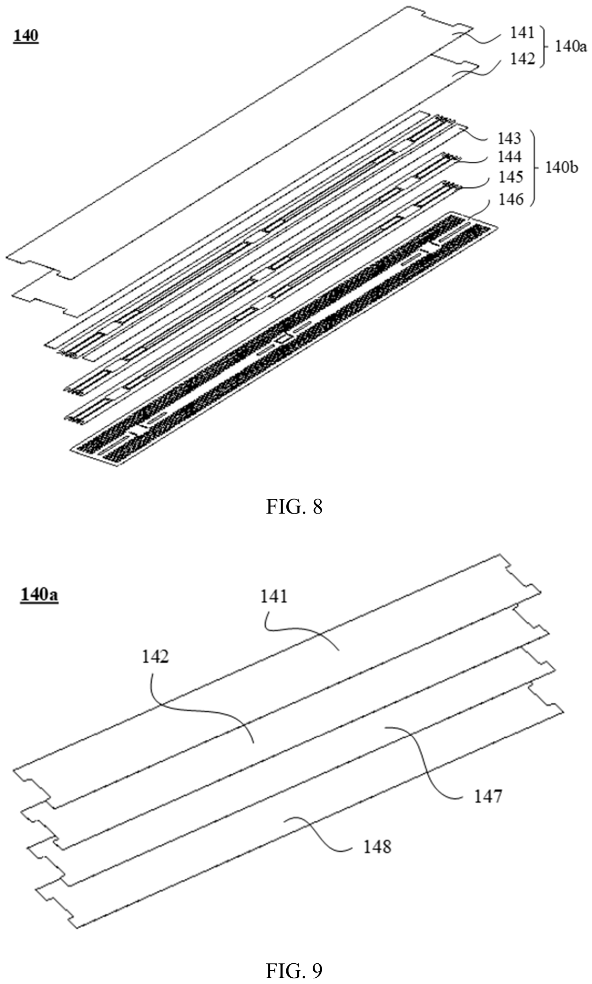

The following continues to describe structural details of the flexible cushioning layer 140 with reference to the accompanying drawings. FIG. 8 is an exploded view of the flexible cushioning layer 140 according to an embodiment of this application. As shown in FIG. 8, the flexible cushioning layer 140 is formed by sequentially stacking a plurality of sheets. The flexible cushioning layer 140 includes a first support layer 142 and a first cushioning layer 144 that are stacked, and an elastic modulus of the first support layer 142 is greater than an elastic modulus of the first cushioning layer 144.

The flexible cushioning layer 140 provided in this application is formed by stacking the plurality of sheets including the first support layer 142 and the first cushioning layer 144, and the elastic modulus of the first support layer 142 is greater than that of the first cushioning layer 144. In this way, the first support layer 142 having a greater elastic modulus helps provide a support force for the flexible display 120, and reduce a possibility that the flexible display 120 is recessed toward the inside of the device under impact. In addition, because the first support layer 142 has a greater elastic modulus, an overall deformation amount of the first support layer 142 is smaller under impact waves, and the first support layer 142 is not prone to local stress concentration, so that the impact waves are easily dispersed on the first support layer 142. However, the first cushioning layer 144 has a lower elastic modulus, and can absorb impact waves through greater elastic deformation. This helps absorb impact waves from the flexible display 120, and reliably protect the flexible display 120. In this application, the first support layer 142 and the first cushioning layer 144 are mutually matched and combined to form the flexible cushioning layer 140, so that the flexible cushioning layer 140 can have both cushioning protection effect and supporting effect on the flexible display 120, and further have good bending performance. This improves use performance of the foldable electronic device 100.

In some examples, the elastic modulus of the first support layer 142 may range from 50 GPa to 300 GPa. For example, the first support layer 142 may be a metal sheet. For example, the first support layer 142 may be a steel sheet, an aluminum alloy sheet, a copper alloy sheet, a magnesium alloy sheet, a titanium alloy sheet, or the like.

In some examples, the elastic modulus of the first cushioning layer 144 may range from 10 MPa to 10 GPa. For example, the first cushioning layer 144 may be a non-metallic sheet like an elastic rubber sheet, an elastic plastic sheet, or a polymer material sheet. For example, the first cushioning layer 144 may be a TPU sheet, a PET sheet, a PC sheet, or a PI sheet.

In some examples, the first support layer 142 and the first cushioning layer 144 may be directly attached to each other, or there may be another sheet between the first support layer 142 and the first cushioning layer 144. A stacking sequence of the first support layer 142 and the first cushioning layer 144 is not limited in this application. For example, the first cushioning layer 144 is located between the first support layer 142 and the rotating shaft 113a, or the first support layer 142 is located between the first cushioning layer 144 and the rotating shaft 113a.

In some examples, in addition to the first support layer 142 and the first cushioning layer 144, the flexible cushioning layer 140 may further include another functional film layer or sheet. For example, the flexible cushioning layer 140 may include at least one adhesive layer, to fasten the flexible cushioning layer 140 to the screen holding plate 130, or fasten the first support layer 142 to the first cushioning layer 144.

As shown in FIG. 8, in this embodiment of this application, the flexible cushioning layer 140 includes an under-screen cushioning layer 140a and an on-shaft cushioning layer 140b that are stacked. The under-screen cushioning layer 140a includes a first adhesive layer 141 and the first support layer 142. The first support layer 142 is fastened to the screen holding plate 130 through the first adhesive layer 141. In other words, the first support layer 142 is fastened to the flexible display 120 through the first adhesive layer 141. The on-shaft cushioning layer 140b includes the first cushioning layer 144, a second adhesive layer 145, and a second support layer 146 that are sequentially stacked. The second support layer 146 is fastened to the rotating shaft 113a.

In this application, the flexible cushioning layer 140 is divided into two parts. One part (namely, the under-screen cushioning layer 140a) is fixedly bonded to the flexible display 120, and the other part (namely, the on-shaft cushioning layer 140b) is fastened to the rotating shaft 113a. In this way, when the flexible cushioning layer 140 is assembled, the under-screen cushioning layer 140a may be first reliably bonded to the back side of the flexible display 120, and the on-shaft cushioning layer 140b is fastened (for example, welded) to the rotating shaft 113a. Then, the flexible cushioning layer 140 may be assembled by assembling the flexible display 120. To be specific, after the flexible display 120 is assembled on the foldable assembly 110, the under-screen cushioning layer 140a is automatically attached to the on-shaft cushioning layer 140b. This can simplify assembling steps and improve assembling reliability of the flexible cushioning layer 140.

In some examples, a material of an adhesive layer (for example, the first adhesive layer 141 and/or the second adhesive layer 145) may include but is not limited to a pressure sensitive adhesive (pressure sensitive adhesive, PSA), an optical transparent adhesive, a photosensitive adhesive, a heat-sensitive adhesive, or an ultraviolet-ray (ultraviolet-ray, UV) adhesive. Materials of the first adhesive layer 141 and the second adhesive layer 145 may be the same or different.

In some examples, the hollow part 149 may be located on the under-screen cushioning layer 140a and/or the on-shaft cushioning layer 140b.

In some examples, the first support layer 142 is a steel sheet, with a thickness ranging from 0.02 mm to 0.05 mm. The first cushioning layer 144 is a TPU sheet, with a thickness ranging from 0.03 mm to 0.3 mm. The second support layer 146 is a steel sheet, with a thickness ranging from 0.02 mm to 0.05 mm. In this case, the second support layer 146 is welded to the rotating shaft 113a, to fasten the on-shaft cushioning layer 140b to the rotating shaft 113a.

In some examples, materials of the first support layer 142 and the second support layer 146 may be the same or different. For example, both the first support layer 142 and the second support layer 146 may be steel sheets.

As shown in FIG. 8, the under-screen cushioning layer 140a is of a two-sheet structure including the first adhesive layer 141 and the first support layer 142. In another implementation, the under-screen cushioning layer 140a may alternatively include more (for example, three, four, five, or more) sheets. FIG. 9 is an exploded view of another example of the under-screen cushioning layer 140a according to an embodiment of this application.

As shown in FIG. 9, the under-screen cushioning layer 140a is of a four-layer structure. In addition to the first adhesive layer 141 and the first support layer 142, the under-screen cushioning layer 140a further includes a third adhesive layer 147 and a second cushioning layer 148. The first adhesive layer 141, the first support layer 142, the third adhesive layer 147, and the second cushioning layer 148 are sequentially stacked.

In some examples, the hollow part 149 may be located on the first adhesive layer 141 and the first support layer 142. In this case, the third adhesive layer 147 and the second cushioning layer 148 may not be hollow (for example, may not be notched). Alternatively, the hollow part 149 may be located on the third adhesive layer 147 and the second cushioning layer 148. In this case, the first adhesive layer 141 and the first support layer 142 may not be hollow (for example, may not be notched).

In some examples, a stacking sequence of the first support layer 142 and the second cushioning layer 148 may alternatively be changed. To be specific, the first adhesive layer 141, the second cushioning layer 148, the third adhesive layer 147, and the first support layer 142 are sequentially stacked. In some examples, the hollow part 149 may be located on the first adhesive layer 141 and the second cushioning layer 148. In this case, the third adhesive layer 147 and the first support layer 142 may not be hollow (for example, may not be notched). Alternatively, the hollow part 149 may be located on the third adhesive layer 147 and the first support layer 142. In this case, the first adhesive layer 141 and the second cushioning layer 148 may not be hollow (for example, may not be notched). In some examples, materials of the first cushioning layer 144 and the second cushioning layer 148 may be the same or different. For example, both the first cushioning layer 144 and the second cushioning layer 148 may be TPU sheets.

In some examples, the under-screen cushioning layer 140a includes a plurality of functional film layers that are sequentially stacked. The functional film layer may be, for example, a bonding layer, a support layer, or a cushioning layer. The hollow part 149 is disposed on one or more of the plurality of functional film layers.

That is, the hollow part 149 may be disposed on one or more functional film layers of the under-screen cushioning layer 140a, instead of being disposed on all functional film layers. In other words, a part of functional film layers of the under-screen cushioning layer 140a may not be hollow. In this way, the hollow part 149 can be disposed more flexibly, so that the hollow part 149 can reliably avoid a wave pattern, and further helps ensure that the flexible cushioning layer 140 has good supporting effect on the flexible display 120.

For example, the under-screen cushioning layer 140a includes a plurality of functional film layers that are sequentially stacked, and the hollow part 149 may be located on one or more functional film layers that are in the plurality of functional film layers and that are adjacent to a side of the flexible display 120, in other words, the hollow part 149 may be formed on an upper surface of the under-screen cushioning layer 140a and does not penetrate a lower surface of the under-screen cushioning layer 140a. Alternatively, the hollow part 149 may be located on one or more functional film layers that are in the plurality of functional film layers and that are away from a side of the flexible display 120, in other words, the hollow part 149 may be formed on a lower surface of the under-screen cushioning layer 140a and does not penetrate an upper surface of the under-screen cushioning layer 140a. Alternatively, the hollow part 149 may be located on one or more functional film layers in the plurality of functional film layers, in other words, the hollow part 149 may be formed inside the under-screen cushioning layer 140a, and does not penetrate an upper surface and a lower surface of the under-screen cushioning layer 140a.

For example, the plurality of functional film layers may include at least one support layer (for example, a steel sheet layer), at least one cushioning layer (for example, a TPU layer), and at least one adhesive layer. The at least one support layer and the at least one cushioning layer are alternately disposed sequentially. The support layer and the cushioning layer that are adjacent to each other may be bonded to each other through the adhesive layer. The hollow part 149 may be formed on any support layer, cushioning layer, or adhesive layer.

In some examples, in a width direction perpendicular to the rotating shaft 113a (namely, a radial direction of the rotating shaft 113a), a width of the under-screen cushioning layer 140a is greater than a width of the bendable holding part 133.

The under-screen cushioning layer 140a and the bendable holding part 133 each are of a rectangular structure. A long side of the rectangular structure is disposed in an axial direction of the rotating shaft 113a, and a short side of the rectangular structure is disposed in a direction (namely, a width direction) perpendicular to the rotating shaft 113a. In this application, the width of the under-screen cushioning layer 140a is set to be greater than the width of the bendable holding part 133, in other words, a length of a short side of the under-screen cushioning layer 140a is greater than a length of a short side of the bendable holding part 133, so that the flexible display 120 can be better supported and protected.

For example, orthographic projections, on the under-screen cushioning layer 140a, of two long sides of the bendable holding part 133 are located inside the under-screen cushioning layer 140a.

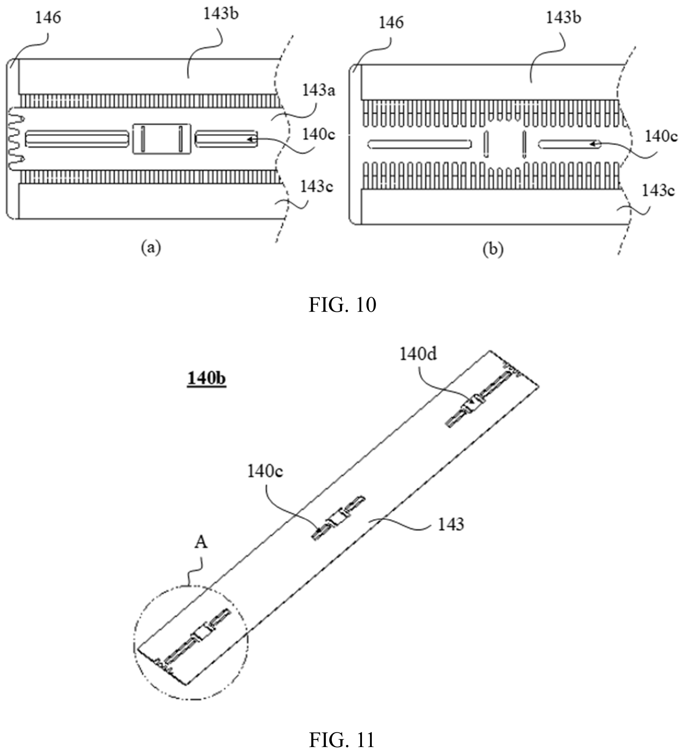

FIG. 10 is a partial diagram of the on-shaft cushioning layer 140b according to an embodiment of this application. Herein, (a) in FIG. 10 is a front view of the on-shaft cushioning layer 140b, and (b) in FIG. 10 is a rear view of the on-shaft cushioning layer 140b. As shown in FIG. 8 and FIG. 10, the on-shaft cushioning layer 140b further includes a lubricating layer 143, and the lubricating layer 143 is located between the under-screen cushioning layer 140a and the first cushioning layer 144. The lubricating layer 143 can achieve lubricating effect. The lubricating layer 143 may be disposed to reduce a friction force between the under-screen cushioning layer 140a and the on-shaft cushioning layer 140b, so that the under-screen cushioning layer 140a and the on-shaft cushioning layer 140b are more likely to have mutual misalignment in a folding process. In this way, a folding feel of the foldable electronic device 100 can be improved.

In some examples, the lubricating layer 143 may be a lubricating coating layer including lubricating oil or grease.

In some examples, the under-screen cushioning layer 140a and a middle part of the on-shaft cushioning layer 140b are fastened to each other, for example, are fixedly bonded to each other, so that the under-screen cushioning layer 140a and the on-shaft cushioning layer 140b can be positioned. In this case, the lubricating layer 143 may be located at edge positions of the under-screen cushioning layer 140a and the on-shaft cushioning layer 140b. In the folding process, the edge positions of the under-screen cushioning layer 140a and the on-shaft cushioning layer 140b may have mutual alignment, so that the foldable electronic device 100 can be folded more easily, in other words, folding is more labor-saving.

In this embodiment of this application, the lubricating layer 143 includes a mylar (mylar) film. The mylar film may be coated on a surface of the first cushioning layer 144. The mylar film has self-lubricating performance, and can reduce friction between the under-screen cushioning layer 140a and the mylar film, and facilitate mutual sliding between the under-screen cushioning layer 140a and the on-shaft cushioning layer 140b during folding. For example, the mylar film may be a PET mylar film or a teflon (teflon) mylar film.

In some examples, the lubricating layer 143 includes a teflon mylar film. Teflon has good sliding performance and wear resistance, and is not easily adhered to another substance. Teflon may be referred to as polytetrafluoroethylene (polytetrafluoroethylene, PTFE), or may be referred to as a "non-sticky coating", an "easy-to-clean material", a "king of plastics", or "Hala". This material has characteristics of acid and alkali resistance and resistance to various organic solvents. In addition, polytetrafluoroethylene has a characteristic of high temperature resistance, and has a very low friction coefficient and lubrication effect. In this way, the teflon mylar film is disposed on the surface of the first cushioning layer 144, so that the on-shaft cushioning layer 140b may have good smoothness.

In some examples, the lubricating layer 143 may alternatively be disposed on a lower (inner) surface of the first support layer 142. In this case, the lubricating layer 143 may be considered as a part of the under-screen cushioning layer 140a. In this way, lubrication effect can be achieved, so that the under-screen cushioning layer 140a and the on-shaft cushioning layer 140b can slide relative to each other when being folded.

As shown in FIG. 8 and FIG. 10, the first cushioning layer 144, the second adhesive layer 145, and the second support layer 146 are sequentially stacked. Areas of the first cushioning layer 144 and the second adhesive layer 145 are the same, and are less than an area of the second support layer 146. The lubricating layer 143 includes a first lubricating part 143a, a second lubricating part 143b, and a third lubricating part 143c. An area of the first lubricating part 143a is approximately the same as the area of the first cushioning layer 144, and the first lubricating part 143a covers the first cushioning layer 144. The second lubricating part 143b and the third lubricating part 143c respectively cover two edges of the second support layer 146, that is, cover a region that is of the second support layer 146 and that is not covered by the first cushioning layer 144. In addition, the second lubricating part 143b and the third lubricating part 143c are approximately of a U-shaped structure, and extend (coat) from a side surface that is of the second support layer 146 and that is away from the rotating shaft 113a to a side surface that is adjacent to (faces) the rotating shaft 113a. In this way, lubricating effect can also be achieved on the adjacent side surface, so that a friction force between the on-shaft cushioning layer 140b and the foldable mechanism 113 can be reduced, and the on-shaft cushioning layer 140b and the foldable mechanism 113 can slide relative to each other during folding.

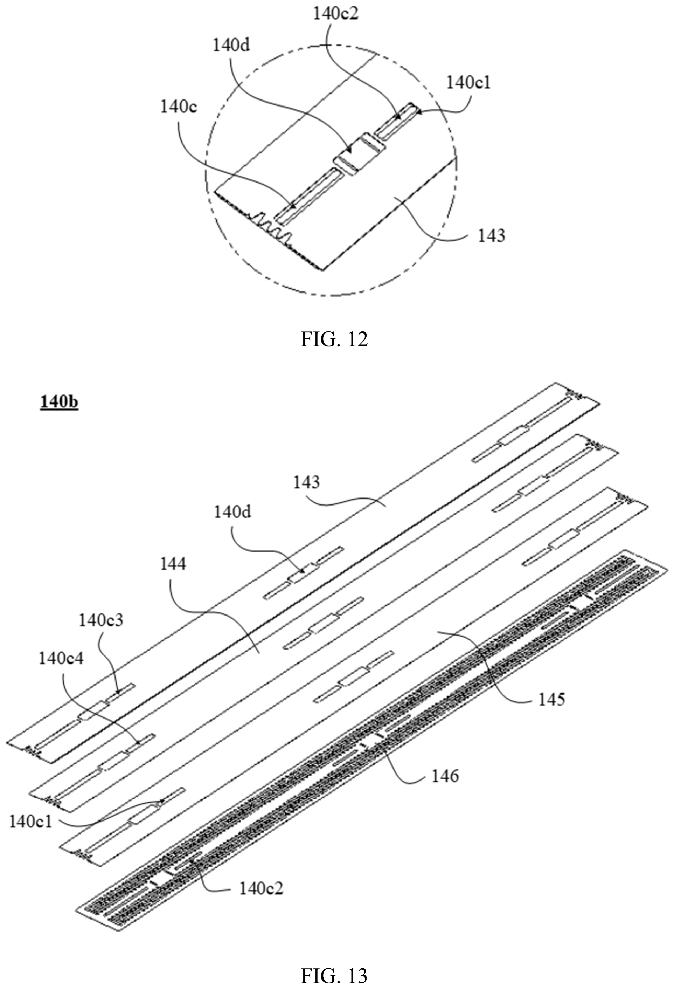

FIG. 11 is a diagram of a structure of another example of the on-shaft cushioning layer 140b according to an embodiment of this application. FIG. 12 is a partially enlarged view of a part A of the on-shaft cushioning layer 140b shown in FIG. 11. FIG. 13 is an exploded view of the on-shaft cushioning layer 140b shown in FIG. 11. As shown in FIG. 11 to FIG. 13, in this embodiment, areas of the first cushioning layer 144, the second adhesive layer 145, and the second support layer 146 are basically the same. For example, widths of the first cushioning layer 144, the second adhesive layer 145, and the second support layer 146 are equal or approximately equal. The lubricating layer 143 is an entire structure (a single part) with a large front surface covering the first cushioning layer 144, and a small rear surface covering an edge region of the second support layer 146.

As shown in FIG. 10 to FIG. 13, a through hole 140c is provided in a middle part of the on-shaft cushioning layer 140b, and the through hole 140c may accommodate glue. The under-screen cushioning layer 140a is bonded to the rotating shaft 113a through the through hole 140c. In this way, the under-screen cushioning layer 140a can be directly fastened to the rotating shaft 113a without using the on-shaft cushioning layer 140b. This can improve reliability of a connection between the bendable display part 123 and the rotating shaft 113a, effectively prevent a risk like warping of the bendable display part 123, and help keep the bendable display part 123 flat.

As shown in (a) in FIG. 10, and FIG. 11 to FIG. 13, a part that is of the through hole 140c and that is located in the second support layer 146 has a smaller diameter than a part that is of the through hole 140c and that is located in the first cushioning layer 144, or in other words, the part that is of the through hole 140c and that is located in the first cushioning layer 144 has a greater diameter than the part that is of the through hole 140c and that is located in the second support layer 146, so that a part of a wall surface of the second support layer 146 is exposed. In this case, the first cushioning layer 144 can effectively block the glue, so that more glue can be accommodated. In addition, the under-screen cushioning layer 140a can be bonded to both the rotating shaft 113a and the second support layer 146, so that connection reliability can be improved.

In some examples, as shown in FIG. 13, the through hole 140c includes a first hole 140c1 provided at the second adhesive layer 145 and a second hole 140c2 provided at the second support layer 146. The first hole 140c1 and the second hole 140c2 are opposite to each other, and a cross-sectional area of the second hole 140c2 is less than a cross-sectional area of the first hole 140c1.

A width of the rotating shaft 113a is small, and the second hole 140c2 has a smaller cross-sectional area, so that overflow of the glue from the hole can be avoided, more glue can be accommodated in the hole, and a part of a wall surface of the second support layer 146 is exposed. In this way, the under-screen cushioning layer 140a can be bonded to both the rotating shaft 113a and the second support layer 146, so that connection reliability can be improved.

As shown in FIG. 13, both the first hole 140c1 and the second hole 140c2 are of a rectangular structure with rounded corners. A width (namely, a length of a short side) of the first hole 140c1 is greater than a width of the second hole 140c2, and a length of the first hole 140c1 is equal to a length of the second hole 140c2, so that the cross-sectional area of the first hole 140c1 is greater than the cross-sectional area of the second hole 140c2.

As shown in FIG. 13, the through hole 140c further includes a third hole 140c3 located at the lubricating layer 143 and a fourth hole 140c4 located at the first cushioning layer 144. The third hole 140c3, the fourth hole 140c4, the first hole 140c1, and the second hole 140c2 are sequentially opposite to each other, and hole walls of the third hole 140c3, the fourth hole 140c4, and the first hole 140c1 are kept flush. In this way, the three holes may be simultaneously formed through one cutting process. In other words, the third hole 140c3, the fourth hole 140c4, and the first hole 140c1 face each other, and have a same cross-sectional area. The cross-sectional areas of the three holes are all greater than the cross-sectional area of the second hole 140c2.

In some examples, the second support layer 146 includes a metal layer, and the metal layer is welded to the rotating shaft 113a. Compared with bonding, welding has stronger connection reliability. In other words, reliability of a connection between the on-shaft cushioning layer 140b and the rotating shaft 113a can be improved. For example, the second support layer 146 is a steel sheet, and there are a plurality of welding spot regions on the steel sheet for welding and fastening to the rotating shaft 113a.

In some examples, one or more through holes 140c may be provided. For example, in an axial direction of the rotating shaft 113a, a plurality of through holes 140c are provided and spaced from each other in the middle part of the on-shaft cushioning layer 140b, to improve bonding reliability.

In some examples, as shown in FIG. 11 to FIG. 13, a welding avoidance hole 140d is provided in a middle part of the on-shaft cushioning layer 140b, and the welding avoidance hole 140d penetrates the metal layer from a surface on a side that is of the on-shaft cushioning layer 140b and that is away of the second support layer 146 (namely, the metal layer). For example, the lubricating layer 143, the first cushioning layer 144, and the second adhesive layer 145 are sequentially penetrated, so that the second support layer 146 is exposed, to facilitate a welding operation performed by a welding joint on the metal layer and the rotating shaft. For example, a bar-shaped through hole may be provided in a region in which the second support layer 146 is exposed, to facilitate welding and fastening of the second support layer 146 to the rotating shaft 113a.

In some examples, one or more welding avoidance holes 140d may be provided. For example, in the axial direction of the rotating shaft 113a, a plurality of welding avoidance holes 140d are provided and spaced from each other in the middle part of the on-shaft cushioning layer 140b, to improve welding reliability.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A foldable electronic device, comprising a foldable assembly (110) and a flexible display (120) laid on the foldable assembly (110), wherein the foldable assembly (110) comprises a first housing (111), a foldable mechanism (113), and a second housing (112) that are sequentially connected to each other, the foldable mechanism (113) comprises a rotating shaft (113a), and the foldable electronic device further comprises:
a flexible cushioning layer (140) disposed between the flexible display (120) and the rotating shaft (113a), wherein the flexible cushioning layer (140) comprises a hollow part (149), and the hollow part (149) is adjacent to an end part of the rotating shaft (113a).

2. The foldable electronic device according to claim 1, wherein the hollow part (149) comprises a hole structure and/or a notch structure.

3. The foldable electronic device according to claim 1 or 2, wherein the flexible cushioning layer (140) comprises a first support layer (142) and a first cushioning layer (144) that are stacked, and an elastic modulus of the first support layer (142) is greater than an elastic modulus of the first cushioning layer (144).

4. The foldable electronic device according to claim 3, wherein the flexible cushioning layer (140) comprises an under-screen cushioning layer (140a) and an on-shaft cushioning layer (140b) that are stacked, wherein
the under-screen cushioning layer (140a) comprises a first adhesive layer (141) and the first support layer (142), and the first support layer (142) is fastened to the flexible display (120) through the first adhesive layer (141); and
the on-shaft cushioning layer (140b) comprises the first cushioning layer (144), a second adhesive layer (145), and a second support layer (146) that are sequentially stacked, and the second support layer (146) is fastened to the rotating shaft (113a).

5. The foldable electronic device according to claim 4, wherein the under-screen cushioning layer (140a) further comprises a third adhesive layer (147) and a second cushioning layer (148); and the first adhesive layer (141), the first support layer (142), the third adhesive layer (147), and the second cushioning layer (148) are sequentially stacked; or
the first adhesive layer (141), the second cushioning layer (148), the third adhesive layer (147), and the first support layer (142) are sequentially stacked.

6. The foldable electronic device according to claim 4, wherein the on-shaft cushioning layer (140b) further comprises:
a lubricating layer (143), located between the under-screen cushioning layer (140a) and the first cushioning layer (144).

7. The foldable electronic device according to claim 6, wherein the lubricating layer (143) comprises a mylar film.

8. The foldable electronic device according to any one of claims 4 to 7, wherein a through hole (140c) is provided in a middle part of the on-shaft cushioning layer (140b), and the under-screen cushioning layer (140a) is bonded to the rotating shaft (113a) by using glue in the through hole (140c).

9. The foldable electronic device according to claim 8, wherein the through hole (140c) comprises a first hole (140c1) provided at the second adhesive layer (145) and a second hole (140c2) provided at the second support layer (146), the first hole (140c1) and the second hole (140c2) are opposite to each other, and a cross-sectional area of the second hole (140c2) is less than a cross-sectional area of the first hole (140c1).

10. The foldable electronic device according to any one of claims 4 to 7, wherein the second support layer (146) comprises a metal layer, and the metal layer is welded to the rotating shaft (113a).

11. The foldable electronic device according to claim 10, wherein a welding avoidance hole (140d) is provided in a middle part of the on-shaft cushioning layer (140b), and the welding avoidance hole (140d) penetrates from a surface of a side that is of the on-shaft cushioning layer (140b) and that is away from the metal layer to the metal layer, to expose the metal layer.

12. The foldable electronic device according to any one of claims 4 to 7, wherein the under-screen cushioning layer (140a) comprises a plurality of functional film layers that are sequentially stacked, and the hollow part (149) is disposed on one or more of the plurality of functional film layers.

13. The foldable electronic device according to any one of claims 4 to 7, wherein the first housing (111) comprises a first middle frame (111a), the second housing (112) comprises a second middle frame (112a), and the foldable electronic device further comprises:
a screen holding plate (130), comprising a first holding part (131), a bendable holding part (133), and a second holding part (132) that are sequentially connected to each other, wherein the first holding part (131) is located between the flexible display (120) and the first middle frame (111a), the bendable holding part (133) is located between the flexible display (120) and the flexible cushioning layer (140), and the second holding part (132) is located between the flexible display (120) and the second middle frame (112a).

14. The foldable electronic device according to claim 13, wherein in a width direction perpendicular to the rotating shaft (113a), a width of the under-screen cushioning layer (140a) is greater than a width of the bendable holding part (133).
